# EUROPÄISCHE PATENTSCHRIFT

(11) **EP 1 626 500 B1**
(45) Veröffentlichungstag und Bekanntmachung des Hinweises auf die Patenterteilung: **15.04.2015**
(21) Anmeldenummer: 05017498.6
(22) Anmeldetag: 11.08.2005
(51) Int. Cl.: H03K 17/95

(54) **Überwachungsschaltung für eine Türe**
Circuit for monitoring a door
Circuit pour la surveillance d'une porte

(30) Priorität: 13.08.2004 DE 102004039389; 13.08.2004 US 601388 P
(43) Veröffentlichungstag der Anmeldung: 15.02.2006
(73) Patentinhaber: Airbus Operations GmbH, 21129 Hamburg (DE)
(72) Erfinder: Rieckmann, Norbert, 22549 Hamburg (DE)
(74) Vertreter: Maiwald Patentanwalts GmbH

(56) Entgegenhaltungen:
- WO-A-89/03537
- DE-A1- 2 727 525

## Beschreibung

Die vorliegende Erfindung betrifft die Überwachung einer Türe in einem Flugzeug. Insbesondere betrifft die vorliegende Erfindung eine Schaltung zur Überwachung einer Position eines Targets, beispielsweise einer Türe eines Flugzeugs sowie ein entsprechendes Verfahren.

In Flugzeugen kommen eine Vielzahl von Türen zum Einsatz. Es gibt Außentüren, die den Zutritt von außen in den Passagierraum ermöglichen und Frachtladetüren. Eine ungewollt geöffnete Tür führt zu Problemen durch Druckabfall in der Kabine und Beschädigung der Flugzeugstruktur durch abgerissene Türen.

Um unbeabsichtigtes Öffnen der Türen zu verhindern, werden die Türen durch einen aufwendigen Verriegelungsmechanismus in der geschlossenen Position gehalten. Vor dem Start muss sichergestellt sein, dass alle Verriegelungsmechanismen in der Stellung "geschlossen und gesichert" sind. Deswegen wird die aktuelle Position der Verriegelungen durch Näherungsschalter überwacht und zentral ausgewertet und angezeigt.

Diese Näherungsschalter sind meist als Induktivität mit Ferritkern ausgebildet. Er wird als freischwingender Oszillator betrieben. Wird an diesen ein magnetischer Leiter (Target), der an der zu überwachenden Mechanik angebracht sein kann, angenähert, verändert sich der magnetische Widerstand der Anordnung, damit die Induktivität und damit der Oszillator sein Schwingungsverhalten, woran eine Positionsänderung der Verriegelungen eines Türblattes erkannt werden kann. Der in den Induktivitäten eingesetzte Ferritkern wird heute benötigt, um eine ausreichende Empfindlichkeit und somit ein sicheres Erkennen der Öffnungsposition des Türblattes sicherzustellen. Allerdings weisen die Ferritkerne ein hohes Gewicht auf. Dies wirkt sich bei Flugzeugen, bei denen es auf die Gewichtseinsparung ankommt, negativ aus.

Aus DE 2727525 ist eine Absorbtions-Messanordnung bekannt, bestehend aus einer Auswertungs- und Schaltelektronik, die ein Steuersignal abgeben kann aus einem Geberteil mit Oszillator, sowie einem in einer diskreten Entfernung angebrachten Sensorteil, welcher dem Geberteil über einen Kopplungsmechanismus Energie entzieht und bei Annäherung eines Materials an den Sensorteil einen Schaltimpuls auslöst, wobei die Energieaufnahme des Sensorteils aus dem Geberteil bei Annäherung von Materialien an den Sensorteil vermindert ist, und/oder eine Systementkopplung zwischen Sensor- und Geberteil eintritt.

Es ist eine Aufgabe der vorliegenden Erfindung, eine verbesserte Überwachungsschaltung zur Überwachung einer Position eines Targets anzugeben.

Der Gegenstand der Erfindung ergibt sich aus den Merkmalen der unabhängigen Ansprüche. Ausführungsbeispiele sind in den abhängigen Ansprüchen angegeben.

Gemäß einem Aspekt der vorliegenden Erfindung wird eine Überwachungsschaltung zur Überwachung einer Position eines Targets angegeben. Die Überwachungsschaltung umfasst ein induktives System. Das induktive System umfasst eine Vielzahl von Luftspulen und eine Vielzahl von Kondensatoren. Das induktive System ist dabei so ausgestaltet, dass in Abhängigkeit von der Entfernung des Targets zu dem induktiven System ein Frequenzgang des induktiven Systems verändert wird.

In vorteilhafter Art und Weise umfassen die Luftspulen keine Ferritkerne oder ähnliche Kerne, die ein zusätzliches Gewicht bedeuten würden. Das induktive System ist z.B. derart ausgestaltet, dass es bevorzugt auf magnetisch leitfähige Targets anspricht. Dadurch kann das induktive System unempfindlich gegenüber Störungen gemacht werden, die von anderen Gegenständen herrühren können, die nicht aus eisenhaltigem Material hergestellt sind und sich in der Nähe des induktiven Systems befinden können. Außerdem kann als Target ein billiges Eisenblech zum Einsatz kommen. In Abhängigkeit von der Entfernung des Targets zu dem induktiven System kann sich ein Frequenzgang in Amplitude und Mittenfrequenz des induktiven Systems ändern. In vorteilhafter Art und Weise kann somit eine Abbildung einer räumlichen Größe, der Entfernung eines Targets von dem induktiven System, in eine elektrisch messbare und auswertbare Größe, der geänderten Form eines Frequenzgangs, gewandelt werden. Durch Anbringung des Targets auf dem Türblatt und des induktiven Systems an der Türzarge beispielsweise kann der Abstand des Targets zu dem induktiven System dem Abstand einer geöffneten Türe entsprechen. Es kann somit also ermöglicht werden, den Abstand in eine elektrisch messbare Größe zu wandeln.

Gemäß einem weiteren Ausführungsbeispiel der vorliegenden Erfindung, wie in Anspruch 2 angegeben, umfasst die Überwachungsschaltung ferner einen Sägezahngenerator und einen Voltage Controlled Oscillator. Der Sägezahngenerator und der Voltage Controlled Oscillator bilden einen Wobbelsender aus, der ein vorbestimmtes Frequenzspektrum durchläuft. Mit diesem Frequenzspektrum kann der Wobbelsender das induktive System anregen.

In vorteilhafter Art und Weise kann von dem Wobbelsender ein Spannungsverlauf mit einem bekannten Frequenzverlauf erzeugt werden. Mit diesem bekannten Frequenzverlauf kann das induktive System angeregt werden. Das induktive System kann jedoch den bekannten Frequenzverlauf beeinflussen. Dabei kann ein neuer Frequenzverlauf entstehen, dessen Form von den Resonanzeigenschaften des induktiven Systems abhängt. Da die Entfernung des Targets von dem induktiven System die Resonanzeigenschaften des induktiven Systems verändern kann, kann der Frequenzverlauf von der Entfernung, die das Target zu dem induktiven System hat, abhängen. Wird eine bestimmte Form des Frequenzgangs erkannt, kann von ihr auf den Abstand des Targets zu dem induktiven System geschlossen werden. Eine Bestimmung, beispielsweise einer Türposition, kann somit ermöglicht werden.

Das induktive System kann einen bekannten Frequenzgang in Abhängigkeit einer Targetposition beeinflussen. Es können danach neue Frequenzgänge vorliegen, die typisch für eine bestimmte Targetposition sein können. Eine Auswerteeinheit, die in der Lage ist, die Amplituden von Frequenzgängen bei mehreren Frequenzen zu unterscheiden, kann damit die Position eines Targets bestimmen.

Gemäß einem Aspekt der Erfindung wird eine Überwachungsschaltung angegeben, deren Auswerteeinheit eine Vielzahl von Bandfiltern umfasst, wobei die Mittenfrequenz eines ersten Bandfilters einer ersten Frequenz entspricht und wobei ein Schwellwert der ersten Frequenz einer unteren Frequenz des induktiven Systems bei einer ersten Targetposition entspricht. Der erste Bandfilter ist ausgebildet ein erstes Signal mit der ersten Frequenz durchzulassen. Die Mittenfrequenz eines zweiten Bandfilters entspricht einer zweiten Frequenz, die einer Resonanzfrequenz des induktiven Systems bei einer zweiten Targetposition entspricht. Der zweite Bandfilter ist ausgebildet, ein zweites Signal mit der zweiten Frequenz durchzulassen.

In vorteilhafter Art und Weise lassen die Filter nur Signale bestimmter Frequenzen durch. Signale anderer Frequenzen werden im Wesentlichen gedämpft, so dass sie nur geschwächt oder überhaupt nicht am Ausgang des Filters ankommen können. D. h. dass nur ein kleiner Ausschnitt eines Frequenzgangs, der um die Mittenfrequenz des Bandfilters liegt, ungedämpft durchgelassen wird. Die Frequenzgänge des induktiven Systems können in Abhängigkeit von der Targetposition beeinflusst werden und können somit unterschiedlich ausgeformt sein und sie können bei unterschiedlichen Frequenzen eine unterschiedliche Signalstärke aufweisen. Durch das Filtern bestimmter Bereiche des Frequenzgangs können die interessierenden Bereiche isoliert werden. Die bei dieser Filterung gewonnenen Signale können nachfolgenden Systemen zur Weiterverarbeitung zugeführt werden.

Gemäß einem weiteren Ausführungsbeispiel der vorliegenden Erfindung, wie in Anspruch 3 angegeben, wird eine Überwachungsschaltung angegeben, deren Auswerteeinheit ferner eine Vielzahl von Komparatoren umfasst. Die Komparatoren können Ausgangssignale in Abhängigkeit des Vergleiches des ersten und des zweiten Signals liefern.

Die Signale an den Ausgängen der Bandfilter weisen unterschiedliche Signalstärken auf. Die Signalstärken entsprechen dabei unterschiedlich hohen Spannungen der Frequenzgänge bei unterschiedlichen Targetpositionen. Da ein Komparator ausgebildet ist unterschiedliche Spannungen zu vergleichen, kann festgestellt werden, welche Spannung grösser ist. Somit können an den Ausgängen der Komparatoren Signale bereitgestellt werden, die mit der Entfernung des Targets von den Luftspulen zusammenhängen.

Gemäß einem weiteren Ausführungsbeispiel der vorliegenden Erfindung, wie in Anspruch 4 angegeben, wird eine Überwachungsschaltung angegeben, die ferner eine Anzeigeeinheit umfasst. Dabei umfasst die Anzeigeeinheit Leuchtanzeigen, die unterschiedliche Targetpositionen anzeigen können.

In vorteilhafter Art und Weise können somit Signalzustände, die beispielsweise an den Ausgängen von Komparatoren anliegen, sichtbar gemacht werden. Unterschiedliche Anzeigemuster der Leuchtanzeigen können unterschiedlichen Targetpositionen entsprechen, wodurch es möglich wird, schnell die Position eines Targets und somit beispielsweise die Öffnung einer Türe zu erfassen. Für einen Bediener beispielsweise, der eine Türöffnung zu überwachen hat, kann es einfacher sein, eine Anzeige, die mit einer Türposition übereingeht, zu überwachen, als beispielsweise einen Frequenzgang zu messen.

Gemäß einem weiteren Ausführungsbeispiel der vorliegenden Erfindung, wie in Anspruch 5 angegeben, umfasst die Überwachungsschaltung weiter eine Alarmeinheit, wobei die Alarmeinheit bei einer bestimmten Position des Targets einen Alarm gibt.

In vorteilhafter Art und Weise kann somit ein Alarm ausgelöst werden, wenn eine bestimmte Targetposition erreicht wird. Dies kann z. B. bei einer bestimmten Öffnungsposition einer Türe der Fall sein. Es könnte wichtig sein, dass solch eine Situation erkannt wird, um ggf. die Türe rechtzeitig wieder schließen zu können. Das Auslösen eines Alarms bei einer bestimmten Position kann es ermöglichen, dass eine ständige Überwachung einer Anzeige oder eines Signalverlaufes nicht vonnöten ist.

Gemäß einem weiteren Ausführungsbeispiel der vorliegenden Erfindung, wie in Anspruch 6 angegeben, wird eine Überwachungsschaltung angegeben, die ausgestaltet ist einen Öffnungszustand einer Türe eines Laderaums eines Flugzeugs zu überwachen.

Bei Flugzeugen, die zum Transport von Gütern bestimmt sind, kann es nötig sein , die Öffnung einer Türe zu überwachen. In vorteilhafter Art und Weise kann sich durch Einsatz einer Überwachungsschaltung gemäß der vorliegenden Erfindung ein schneller Überblick über die Öffnungsposition einer Türe verschafft werden.

Gemäß einem weiteren Aspekt der Erfindung wird ein Verfahren zur Überwachung einer Position eines Targets angegeben. Dazu wird zunächst eine Vielzahl von Luftspulen und eine Vielzahl von Kondensatoren bereitgestellt. Das Target wird derart an die Luftspulen angenähert, dass sich ein Frequenzgang des induktiven Systems verändert. Diese Änderung des Frequenzgangs kann zur Überwachung der Türe ausgewertet werden.

Vorteilhaft lässt sich mit diesem Verfahren beispielsweise die Öffnung einer Türe überwachen, um so möglicherweise rechtzeitig eingreifen zu können, wenn sich die Türe ungewollt öffnet.

Die Anwendung des Sensors ist nicht ausschließlich auf Flugzeugtüren begrenzt. Darüber hinaus kann sie beispielsweise in weiteren Fahrzeugen oder in immobilen Gegenständen eingesetzt werden.

Im Folgenden werden Ausführungsbeispiele der vorliegenden Erfindung mit Verweis auf die folgenden Figuren detailliert beschrieben.
Fig. 1 zeigt ein Blockschaltbild einer Türüberwachungsschaltung gemäß einem Ausführungsbeispiel der vorliegenden Erfindung.
Fig. 2 zeigt ein detailliertes Blockschaltbild des induktiven Systems gemäß einem Ausführungsbeispiel der vorliegenden Erfindung.
Fig. 3 zeigt ein detailliertes Blockschaltbild einer Auswerte- und Anzeigeeinheit gemäß einem Ausführungsbeispiel der vorliegenden Erfindung.
Fig. 4 zeigt Frequenzgänge des induktiven Systems bei verschiedenen Targetpositionen gemäß einem Ausführungsbeispiel der vorliegenden Erfindung.
Fig. 5 zeigt Filterdurchlasskurven von zwei Bandpassfiltern gemäß einem Ausführungsbeispiel der vorliegenden Erfindung.
Fig. 6 zeigt den Frequenzgang des induktiven Systems bei entferntem Target zusammen mit den Filterdurchlasskurven gemäß einem Ausführungsbeispiel der vorliegenden Erfindung.
Fig. 7 zeigt den Frequenzgang des induktiven Systems bei nahem Target zusammen mit den Filterdurchlasskurven gemäß einem Ausführungsbeispiel der vorliegenden Erfindung.

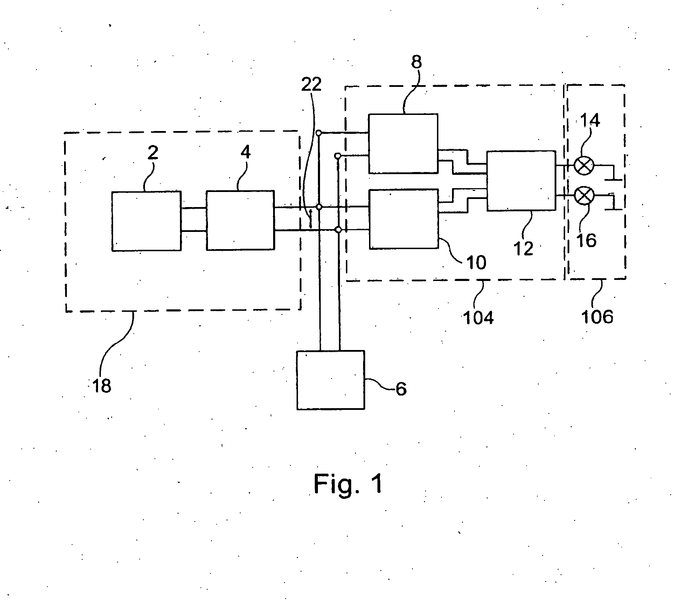

Fig. 1 zeigt ein Blockschaltbild einer Türüberwachungsschaltung gemäß einem Ausführungsbeispiel der vorliegenden Erfindung. Das Bild zeigt vier große Funktionsblöcke, die miteinander in Verbindung stehen. Im Einzelnen handelt es sich dabei um den Wobbelgenerator 18, das induktive System 6, die Auswerteeinheit 104 und die Anzeigeeinheit 106. Der Wobbelgenerator 18 dient als Anregung für das System und besteht aus dem Sägezahngenerator 2 und dem Voltage Controlled Oscillator (VCO) 4. Die Auswerteeinheit 104 wird gebildet von einem Bandfilter 8 mit Mittenfrequenz 38 (f1), einem Bandfilter 10 mit Mittenfrequenz 40 (f2) und einem Komparator 12. Die Anzeigeeinheit setzt sich aus den Leuchtanzeigen 14 und 16 zusammen.

Der Sägezahngenerator 2 erzeugt eine sägezahnförmige Spannung, mit der er den VCO 4 ansteuert, worauf dieser ein vorbestimmtes Frequenzspektrum durchläuft und Spannungen 22 mit den entsprechenden Frequenzen erzeugt. Dieses Frequenzspektrum wird auf das induktive System 6 geschalten. Das induktive System 6 verändert das von dem VCO 4 angebotene Frequenzspektrum in Abhängigkeit der Entfernung eines Targets 20 von dem induktiven System 6. Das induktive System 6 dient also als Sensor für die Entfernung des Targets von dem induktiven System 6. Das induktive System 6 ist parallel zu dem Ausgang des VCO 4 und zu den Eingängen der Bandfilter 8 und 10 geschalten. Somit liegen an dem Ausgang des VCO 4 bzw. an den Eingängen der Bandfilter 8 und 10 die selben Spannungen an. Die Bandfilter 8 und 10 bilden zusammen mit dem Komparator 12 die Auswerteeinheit 104. Die Bandfilter 8, 10 lassen jeweils nur ein bestimmtes Frequenzspektrum der Eingangsspannung 22 durch. Bandfilter 8 ist auf eine erste Frequenz 38 (f1) und Bandfilter 10 ist auf eine zweite Frequenz 40 (f2) voreingestellt. Wenn die Frequenz des Eingangssignals in der Nähe der Frequenz 38 (f1) liegt, liegt am Ausgang des Bandfilters 8 ein Signal an. Wenn die Frequenz des Eingangssignals im Bereich der Frequenz 40 (f2) liegt, liegt am Bandfilter 10 ein Ausgangssignal an. Die Ausgangssignale der Bandfilter 8, 10 vergleicht der Komparator 12 miteinander und abhängig von dem Verhältnis der Ausgangssignale schaltet er entweder die Leuchteinheit 14 oder die Leuchteinheit 16 ein. Die entsprechende Leuchteinheit 14, 16 kann also zur Anzeige eines detektierten Frequenzganges verwendet werden: Da der Frequenzgang mit dem Abstand eines Targets vom induktiven System abhängt, kann die Leuchteinheit 14 bzw. 16 die Position eines Targets anzeigen. Ist das Target 20 mit einem Türblatt und das induktive System 6 mit der Türzarge verbunden, so kann diese Anordnung zur Überwachung der Öffnung einer Türe eingesetzt werden.

Da die verwendeten Frequenzen in weiten Grenzen variierbar sind, kann eine gegenseitige Beeinflussung mit andere Systeme minimiert werden. Beispiele solcher Systeme sind die bodengebundene Stromversorgung mit 50 Hz, die Stromversorgung im Flugzeug mit 400Hz oder Datenleitungen mit 12,5 Hz. Wegen der Variabilität der Frequenzen in weiten Grenzen kann das Überwachungssystem so ausgelegt werden, dass es weit entfernt von den ggf. störenden Frequenzen anderer Systeme operiert. Außerdem kann wegen der Variabilität der Frequenzen die Auswahl der Bauelemente vereinfacht werden. Es muss nicht aufteure Sonderanfertigungen oder Präzisionsbauteile für feste Frequenzen zurückgegriffen werden.

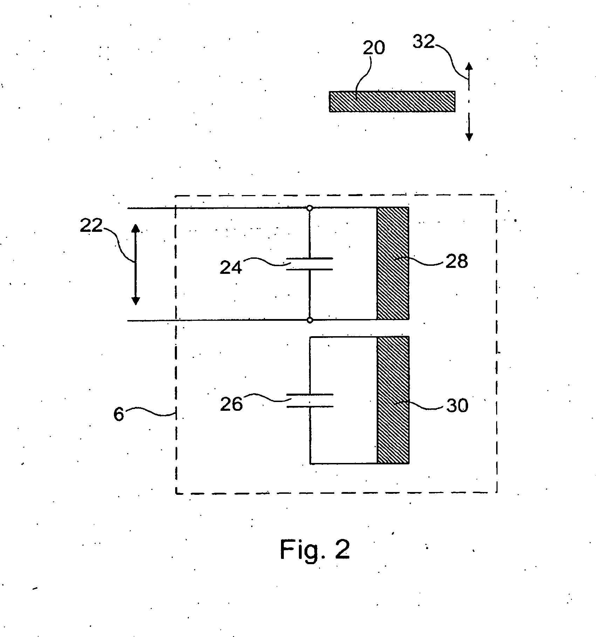

Fig. 2 zeigt ein detailliertes Blockschaltbild des induktiven Systems 6 gemäß einem Ausführungsbeispiel der vorliegenden Erfindung. Das Bild zeigt den Aufbau des induktiven Systems 6, das als Sensor zur Erkennung des Abstands eines Targets 20 zu dem induktiven System 6 dient. Der Sensor 6 besteht aus zwei Schwingkreisen die aus den Luftspulen 28, 30 und den zu den Spulen parallel geschalteten Kondensatoren 24, 26 gebildet werden. Vorteilhaft ist der Einsatz von Luftspulen 28, 30 bei Flugzeugen, da bei Luftspulen keine Spulenkerne zur Verstärkung der Magnetfelder benötigt werden. Diese Kerne würden ein zusätzliches Gewicht bedeuten und dem Bestreben beim Flugzeugbau möglichst viel Gewicht einzusparen entgegen wirken. Bei dem Target 20 handelt es sich um einen magnetisch leitfähigen oder eisenhaltigen Leiter, der aus billigem Eisenblech, z. B. ST 37, gebildet sein kann.

Am Sensoreingang liegt die Spannung 22 an, die von dem Wobbelgenerator 18 erzeugt wird und ebenfalls an den Bandfiltern 8 und 10 parallel anliegt. Der Kondensator 24 und die Luftspule 28 bilden einen ersten Schwingkreis, während der Kondensator 26 und die Luftspule 30 einen zweiten Schwingkreis bilden. Der erste und der zweite Schwingkreis sind nicht miteinander über Leitungen verbunden. Es kann lediglich zu einer magnetischen Kopplung kommen, wenn die Luftspule 28 in der Luftspule 30 ein Magnetfeld induziert. Der erste Schwingkreis weist eine Resonanzfrequenz f₀₁ auf, während der zweite Schwingkreis eine Resonanzfrequenz f₀₂ besitzt. Dabei ist f₀₁ halb so groß wie f₀₂. Die Kapazitäten der beiden Kondensatoren 24 und 26 sind gleich groß gewählt, während die Spule 30 den 1,4-fachen Wert der Spule 28 besitzt. Durch Variationen der Größenverhältnisse der Spulen 30 und 28 kann der Abstand zwischen f₀₁ und f₀₂ verändert werden.

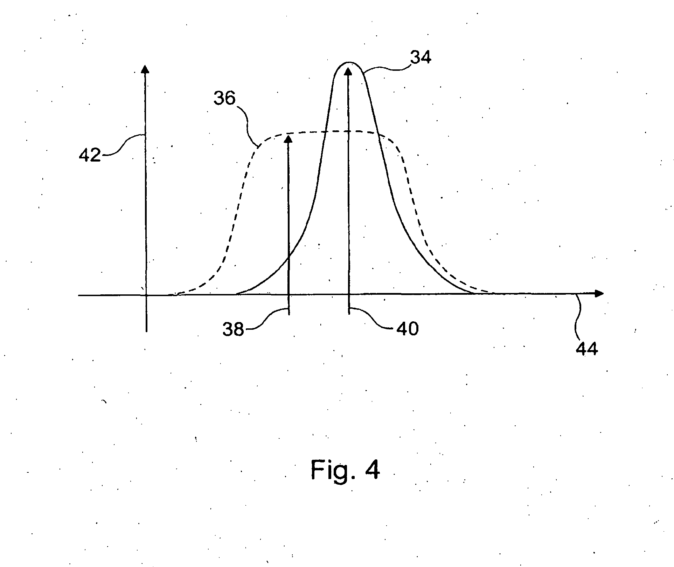

Ist das Target 20 in Richtung 32 weit von dem induktiven System 6 entfernt, so steht der Sensorspannung 22 ein Eingangswiderstand entgegen, der hauptsächlich von Kondensator 24 und Spule 28 gebildet werden. Dieser Eingangswiderstand beeinflusst den Frequenzgang der Spannung 22. Da Temperatureinflüsse auf die Kapazitäten gleich wirken, können mit dieser Anordnung Temperatureinflüsse auf Kapazitäten kompensiert werden. Nähert sich das Target 20 dem induktiven System, entsteht eine stärkere Kopplung zwischen dem ersten Schwingkreis, gebildet aus Kondensator 24 und Luftspule 28, und dem zweiten Schwingkreis, gebildet aus Kondensator 26 und Luftspule 30. Dadurch verändert sich der der Spannung 22 entgegenstehende Widerstand und der damit verbundene Frequenzgang. Der erste Schwingkreis wird durch die stärkere Kopplung der Schwingkreise stärker gedämpft, seine Bandbreite wird erhöht und auch verschoben. Dieses Verhalten wird in Fig. 4 näher erläutert.

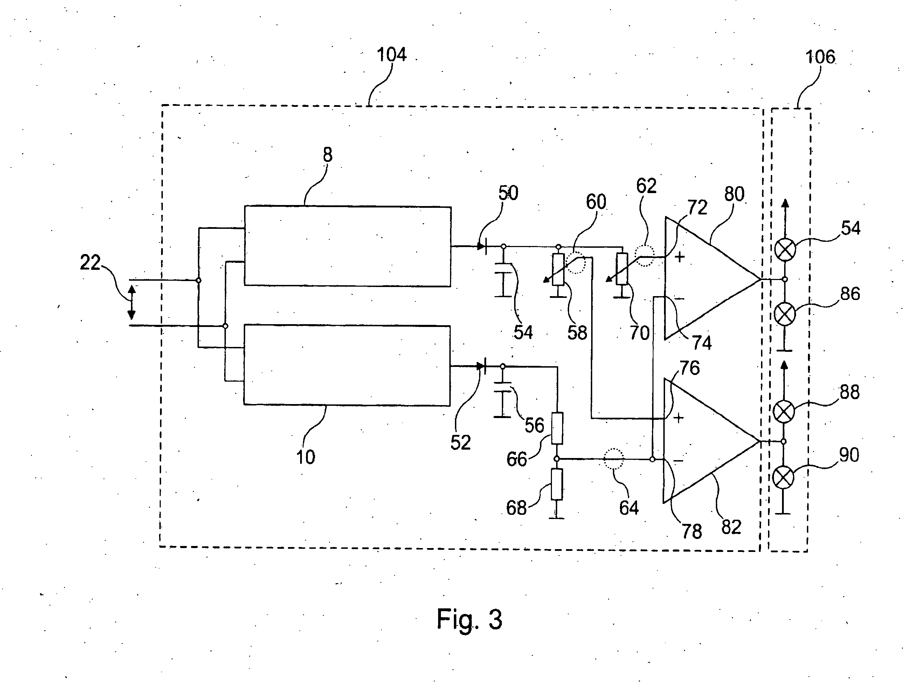

Fig. 3 zeigt ein detailliertes Blockschaltbild einer Auswerte- und einer Anzeigeeinheit gemäß einem Ausführungsbeispiel der vorliegenden Erfindung. Die Auswerteeinheit 104 besteht aus dem Bandfilter 8 mit der Mittenfrequenz 38 (f1) und dem Bandfilter 10 mit der Mittenfrequenz 40 (f2). Diese Bandfilter lassen Signale nur in der Nähe ihrer Mittenfrequenz durch und sind somit für den Frequenzgang selektiv. An ihren Ausgängen sind die Anoden der Diode 50 und 52 angeschlossen und an den Kathoden der Dioden sind die Kondensatoren 54 und 56 gegen Masse verbunden. Diode 50 und Kondensator 54 dienen der Glättung und Gleichrichtung des Ausgangssignals des Bandfilters 8, Diode 52 und Kondensator 56 dienen der Glättung und Gleichrichtung des Ausgangssignals des Bandfilters 10. Das Ausgangssignal des Bandfilters 8 wird nach der Glättung den Potentiometern 58 und 70 zugeführt, durch die sich Schaltschwellen für die Komparatoren 80 und 82 einstellen lassen. Das an Potentiometer 58 abgegriffene Ausgangssignal 60 liegt an dem positiven Eingang des Komparators 82 an. Die an Potentiometer 70 abgegriffene Spannung 62 liegt an dem positiven Eingang 72 des Komparators 80 an. Das geglättete und gleichgerichtete Ausgangssignal des Bandfilters 10 wird über einen Spannungsteiler, der aus den Widerständen 66 und 68 gebildet wird, geführt. Die Spannung 64, die mit Hilfe des Spannungsteilers aus Widerstand 66 und Widerstand 68 auf eine zu den Ausgangssignalen des Bandfilters 8 vergleichbare Größe eingestellt wird, wird den negativen Eingängen 74 und 78 der Komparatoren 80 und 82 zugeführt. Dadurch lassen sich die Ausgänge der Bandfilter 8 und 10 miteinander vergleichen und somit Signalstärken einer bestimmten Frequenz feststellen. Durch Veränderung der Potentiometer 58 und 70 lassen sich verschiedene Schaltschwellen einstellen. Da die Frequenzgänge und somit die Signalstärke an den Ausgängen der Bandfilter 8 und 10 von den Abständen des Targets 20 gegenüber dem induktiven System 6 abhängen, entsprechen die Schaltschwellen verschiedenen Targetdistanzen. Die Ausgänge der Komparatoren 80 und 82 und somit die Ausgänge der Auswerteeinheit 104 sind mit der Anzeigeeinheit 106 verbunden. Der Ausgang des Komparators 80 ist mit den Leuchteinheiten 84 und 86 verbunden, während der Ausgang des Komparators 82 mit den Leuchteinheiten 88 und 90 verbunden ist. An den positiven Eingängen 72 und 76 der Komparatoren 80 und 82 liegt ein Gleichspannungssignal an, welches der Amplitude bei der Mittenfrequenz des ersten Bandfilters 8 entspricht. An den Negativeingängen 74 und 78 der Komparatoren 80 und 82 liegt ein Gleichspannungssignal an, welches der Amplitude der Spannung 22 bei der Mittenfrequenz des Bandfilters 10 entspricht. Wenn das Signal am positiven Eingang 72 des Komparators 80 größer als das Signal am negativen Eingang 74 des Komparators 80 ist, so ist der Ausgang des Komparators 80 ebenfalls positiv. Dadurch leuchtet die Leuchteinheit 86, während die Leuchteinheit 84 dunkel bleibt. Leuchteinheit 84 entspricht einer Position "Fern 1", während Leuchteinheit 86 der Position "Nah 1" entspricht. Wenn der negative Eingang 74 des Komparators 80 ein positiveres Signal als der positive Eingang 72 besitzt, so ist der Ausgang des Komparators 80 negativ, wodurch die Leuchteinheit 84 leuchtet, während die Leuchteinheit 86 dunkel bleibt. Ist bei Komparator 82 der positive Eingang 76 positiver gegenüber dem negativen Eingang 78, so besitzt der Ausgang des Komparators 82 einen positiven Wert. Dadurch leuchtet die Leuchteinheit 90, während die Leuchteinheit 88 dunkel bleibt. Die Leuchteinheit 88 entspricht der Position mit der Bezeichnung "Fern 2", während die Leuchteinheit 90 der Position und der Bezeichnung "Nah 2" entspricht. Besitzt der negative Eingang 78 des Komparators 82 gegenüber dem positiven Eingang 76 einen positiveren Wert, so erhält der Ausgang des Komparators 82 einen negativen Wert, wodurch die Leuchteinheit 88 leuchtet, während die Leuchteinheit 90 dunkel bleibt. Da der Frequenzgang der Spannung 22 von der Targetposition des Targets 22 gegenüber dem induktiven System 6 abhängt, lässt sich mit Anzeigeeinheit 106 somit eine den Abständen entsprechende Anzeige der Leuchteinheiten 84, 86, 88 und 90 erreichen. Die Eichung, welche der Leuchteinheiten "Fern 1", "Nah 1", "Fern 2" oder "Nah 2" bei welcher Targetposition leuchtet kann über die Wahl der Potentiometer 58 und 70 und dem Spannungsteiler aus Widerstand 66 und Widerstand 68 eingestellt werden.

Da lediglich die Spannungsdifferenzen betrachtet werden, ist die Schaltung weitestgehend von der Schwankung der Versorgungsspannung unabhängig. Da die Anzahl der benötigten diskreten Bauelemente gering ist, lässt sich die Schaltung im Wesentlichen mit zwei Massen-ICs, z. B. LM 324 und LM 556, realisieren.

Fig. 4 zeigt Frequenzgänge des induktiven Systems bei verschiedenen Targetpositionen gemäß einem Ausführungsbeispiel der vorliegenden Erfindung. Das Bild zeigt ein Koordinatensystem, an dessen Abszisse 44 die Frequenz und an dessen Ordinate 42 die Spannung des Signals 22 aufgetragen ist. In das Koordinatensystem eingetragen sind die beiden Frequenzgänge 34 und 36. Frequenzgang 34 ergibt sich, wenn das Target 20 weit von dem induktiven System 6 entfernt ist und somit nur der Kondensator 24 und die Luftspule 28 auf die Eingangsspannung 22 wirken. Die Resonanzfrequenz des Frequenzgangs 34 entspricht der Resonanzfrequenz des ersten Schwingkreises, gebildet aus Kondensator 24 und 28. Bei Annäherung des Targets 20 an das induktive System 6 wird der Schwingkreis gedämpft, weshalb die Amplitude verringert wird. Gleichzeitig erhöht sich die Bandbreite und die Mittenfrequenz bewegt sich in die Nähe der Resonanzfrequenz des Schwingkreises, gebildet aus Kondensator 26 und Luftspule 30. Den resultierenden Frequenzgang des Signals 22 mit einem angenäherten Target zeigt Kurve 36. Ebenfalls in das Diagramm eingezeichnet sind die Frequenzen der Bandfilter 8, 10. Die Mittenfrequenz 40 des Bandfilters 10 entspricht der Resonanzfrequenz (f₀₁) der Kurve 34. Die Mittenfrequenz des Bandfilters 8 ist in Fig. 4 mit Nr. 38 eingetragen. Die Mittenfrequenz 38 des Filters 8 liegt nahe der unteren Eckfrequenz des Frequenzgangs 36 bei geringster Distanz des Targets 20.

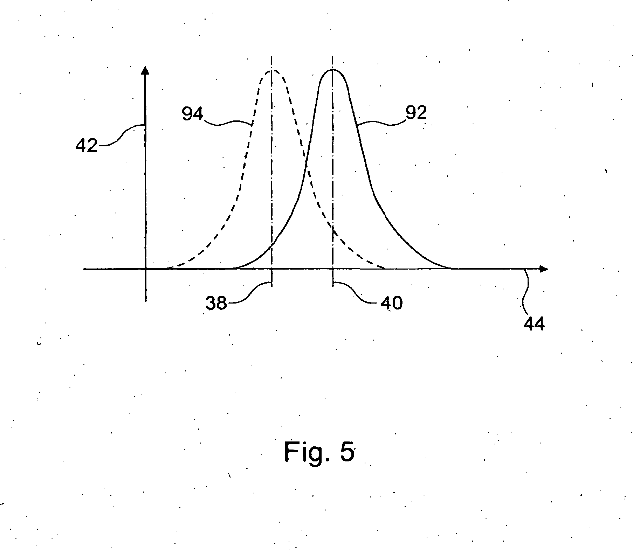

Fig. 5 zeigt Filterdurchlasskurven von zwei Bandpassfiltern 8, 10 gemäß einem Ausführungsbeispiel der vorliegenden Erfindung. Das Bild zeigt auf der Ordinate 44 angetragen die Frequenz und auf der Abszisse 42 angetragen die Spannung, die von den Filtern 8, 10 bei bestimmten Frequenzen durchgelassen wird. Der Verlauf der Filterdurchlasskurve 92 des Bandpassfilters 10 besitzt die Mittenfrequenz 40. Der Frequenzverlauf 94 entspricht der Filterdurchlasskurve des Bandfilters 8 und besitzt die Mittenfrequenz 38. Die beiden Filterdurchlasskurven 92 und 94 überschneiden sich, weshalb keine exakte Trennung der Frequenzen möglich ist. Es kommt somit bei Signalen der Frequenz 40 sowohl am Ausgang des Filters 10 als auch am Ausgang des Bandpassfilters 8 zu einem Ausgangssignal. Allerdings ist das Signal am Ausgang des Bandpassfilters 8 bei Frequenz 40 gegenüber dem Signal am Ausgang des Bandpassfilters 10 stark gedämpft. Ebenso kommt es bei Signalen der Frequenz 38 zu Aktivitäten am Ausgang der Bandpassfilter 8 und 10, wobei das Ausgangssignal des Bandpassfilters 10 gegenüber dem Ausgangssignal des Bandpassfilters 8 stark gedämpft ist.

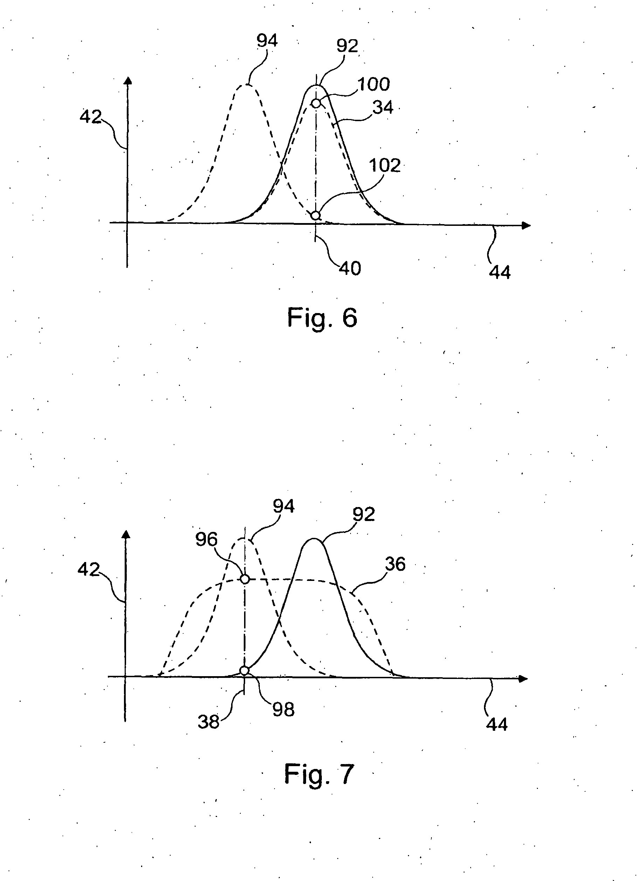

Fig. 6 zeigt den Frequenzgang des induktiven Systems 6 bei entferntem Target zusammen mit den Filterdurchlasskurven 92, 94 gemäß einem Ausführungsbeispiel der vorliegenden Erfindung. In dem Koordinatensystem der Fig. 6 ist an der Abszisse 44 die Frequenz und an der Ordinate 42 die Spannung des Frequenzganges bzw. der Filterdurchlasskurven gezeigt. Die Frequenzdurchlasskurven 92 und 94 wurden in Fig. 5 erklärt. Befindet sich das Target 20 in sehr großer Distanz zu dem induktiven System 6, so entspricht der Frequenzgang des induktiven Systems 6 und somit die Eingangsspannung 22 an den Komparatoren 8 und 10 im Wesentlichen der Kurve 34. Die Resonanzfrequenz (f₀₁) der Kurve 34 fällt mit der Mittenfrequenz 40 des Bandfilters 10 zusammen.

Der Wobbelgenerators 18 durchläuft wiederholend das Frequenzspektrum und regt somit das induktive System an. Das induktive System 6 verändert aufgrund seiner Resonanzeigenschaften den Frequenzgang des von dem Wobbelgenerator 18 erzeugten Signals 22, so dass er im Wesentlichen dem Verlauf der Kurve 34 entspricht. Der Spannungsverlauf der Kurve 34 liegt an den Eingängen der Bandfilter 8 und 10 an. Aufgrund der unterschiedlichen Filtercharakteristiken 92 und 94 der Bandfilter 10 und 8 weisen die Ausgänge der Bandfilter 10, 8 unterschiedliche Signalstärken auf. Bei der Mittenfrequenz 40 des Bandfilters 10 dämpft er das Eingangssignal am wenigsten, während das Eingangssignal von dem Bandfilter 8 sehr stark gedämpft wird. In Fig. 6 soll das durch die Punkte 100 und 102 symbolisiert sein. Dabei soll der Punkt 100 dem Ausgangssignal des Bandfilters 10 bei der Frequenz 40 entsprechen, während der Punkt 102 dem Ausgangssignal des Bandfilters 8 bei dieser Frequenz 40 entsprechen soll. Deshalb wird in diesem Fall das Ausgangssignal des Bandfilters 10 positiver gegenüber dem Ausgangssignal des Bandfilters 8 sein, wodurch das Eingangssignal an den negativen Eingängen 78 und 74 der Komparatoren 82 und 80 positiver gegenüber dem Eingangssignal 62 des positiven Eingangs 72 des Komparators 80 und des Eingangssignals 60 des positiven Eingangs 76 des Komparators 82 ist. Deshalb entsteht sowohl an dem Ausgang des Komparators 80 als auch an dem Ausgang des Komparators 82 ein negatives Ausgangssignal, wodurch die beiden Leuchteinheiten 84 ("Fern 1") und 88 ("Fern 2")aufleuchten und die entfernte Targetposition signalisieren.

Fig. 7 zeigt den Frequenzgang des induktiven Systems 6 bei nahen Targetpositionen zusammen mit den Filterdurchlasskurven 92, 94 gemäß einem Ausführungsbeispiel der vorliegenden Erfindung. Das Bild zeigt ein Koordinatensystem, in dem an der Abszisse 44 die Frequenz und an der Ordinate 42 die Spannung angetragen ist. Die Filterdurchlasskurven 92 und 94 sind aus Fig. 5 bekannt. Bei einer nahen Targetposition kommt es zu einer Kopplung zwischen dem ersten Schwingkreises, gebildet aus Kondensator 24 und Luftspule 28, und dem zweitem Schwingkreis, gebildet aus Kondensator 26 und Luftspule 30. Dadurch entspricht der Frequenzgang der Spannung 22 der Kurve 36. Die Mittenfrequenz 38 des Bandfilters 8 liegt nahe der unteren Eckfrequenz des Frequenzgangs 36. Bei der Mittenfrequenz 38 des Bandpassfilters 8 lässt der Bandpassfilter 8 ein anliegendes Signal 22 nahezu ungedämpft durch, während der Bandpassfilter 10 das Signal weitestgehend dämpft. Die Ausgangssignale der Bandpassfilter 8 und 10 bei der Frequenz 38 sind in Fig. 7 mit den Punkten 96 und 98 angedeutet. Es ist zu sehen, dass das Ausgangssignal 96 von dem Filter 8 positiver als das Ausgangssignal 98 des Bandpassfilters 10 ist. Dadurch sind sowohl das Eingangssignal 62 an dem positiven Eingang 72 des Komparators 80 und das Eingangssignal 60 am positiven Eingang 76 des Komparators 82 positiver gegenüber dem Eingangssignal 64 des negativen Eingangs 74 des Komparators 80 und des negativen Eingangs 78 des Komparators 82. Dadurch ergibt sich sowohl an Komparator 80 als auch an Komparator 82 ein positives Ausgangssignal. Diese positiven Ausgangssignale bewirken, dass die Leuchteinheit 86 und die Leuchteinheit 90, die den beiden Positionen "Nah 1" und "Nah 2" entsprechen, aufleuchten. Somit wird erreicht, dass die nahe Targetposition von den Leuchtsignalen angezeigt wird.

Durch die Potentiometer 58 und 70 lassen sich verschiedene Schaltschwellen einstellen. Somit können noch weitere Targetdistanzen unterschieden werden. Diese weiteren Targetdistanzen würden sich zwischen den beiden Extrempositionen "Target entfernt" und "Target ganz nahe" befinden.

Gemäß einem Ausführungsbeispiel der vorliegenden Erfindung wird ein Verfahren zur Überwachung einer Türe angegeben. Zunächst wird ein Target 20 gegenüber einem induktiven System 6 positioniert. Dabei ist das Target 20 an dem Element angeordnet, dessen Position zu überwachen ist, während das induktive System 6 raumfest angeordnet ist. Das induktive System 6 umfasst eine Vielzahl von Luftspulen 28, 30 und Kondensatoren 24,26. Wird die Türe geöffnet oder geschlossen, verändert sich eine Distanz zwischen dem Target 20 und dem induktiven System 6. Dementsprechend wird ein Frequenzgang 34, 36 des induktiven Systems 6 verändert. Bei weiter Entfernung des Targets 20 von dem induktiven System 6 entspricht der Frequenzgang der Kurve 34, während der Frequenzgang bei kleinster Distanz des Targets zum induktiven System 6 der Kurve 36 entspricht. Mittels einer Auswerteschaltung 104 wird die Änderung des Frequenzganges ausgewertet. Dadurch wird die Position des Targets und somit die Entriegelung und Öffnung der Türe erkannt und schließlich wird diese Position von einer Anzeigeeinheit 106 zur Anzeige gebracht.

Ergänzend ist darauf hinzuweisen, dass "umfassend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Überwachungsschaltung zur Überwachung einer Position eines Targets umfassend:
ein induktives System (6);
wobei das induktive System (6) eine Vielzahl von Luftspulen (28, 30) umfasst; und
wobei das induktive System eine Vielzahl von Kondensatoren (24, 26) umfasst;
wobei die Vielzahl von Luftspulen (28, 30) und die Vielzahl von Kondensatoren (24, 26) zumindest zwei Schwingkreise bilden, die magnetisch gekoppelt sind;
wobei das induktive System ausgestaltet ist in Abhängigkeit von der Entfernung des Targets (20) zu dem induktiven System einen Frequenzgang (34, 36) des induktiven Systems (6) zu verändern, so dass bei angenähertem Target an das induktive System (6) die Bandbreite des Frequenzgangs des induktiven Systems (6) erhöht wird,
ferner umfassend eine Auswerteeinheit (104),
wobei die Auswerteeinheit (104) ausgebildet ist, zumindest zwei Frequenzen (38,40) zu unterscheiden,
wobei die Auswerteeinheit umfasst:
zumindest zwei Bandfiltern (8, 10);
wobei die Mittenfrequenz (38) eines ersten Bandfilters (8) nahe einer ersten Frequenz liegt;
wobei die erste Frequenz eine untere Eckfrequenz des Frequenzganges des induktiven Systems (6) bei angenähertem Target ist;
wobei der erste Bandfilter (8) ausgebildet ist, ein erstes Signal mit der ersten Frequenz durchzulassen;
wobei die Mittenfrequenz (40) eines zweiten Bandfilters (10) eine zweite Frequenz ist;
wobei die zweite Frequenz eine Resonanzfrequenz des induktiven Systems (6) bei entferntem Target ist;
wobei der zweite Bandfilter (10) ausgebildet ist, ein zweites Signal mit der zweiten Frequenz durchzulassen.

2. Überwachungsschaltung nach Anspruch 1, ferner umfassend:
einen Sägezahngenerator (2);
einen Voltage Controlled Oscillator (4);
wobei der Sägezahngenerator und der Voltage Controlled Oscillator einen Wobbelsender (18) ausbilden, der ein vorbestimmtes Frequenzspektrum durchläuft;
wobei der Wobbelsender (18) ausgebildet ist, das induktive System (6) mit dem Frequenzspektrum anzuregen.

3. Überwachungsschaltung nach einem der Ansprüche 1 oder 2, wobei die Auswerteeinheit ferner umfasst:
eine Vielzahl von Komparatoren (80, 82);
wobei die Komparatoren (80, 82) ausgebildet sind Ausgangssignale in Abhängigkeit des Vergleiches des ersten und des zweiten Signals zu liefern.

4. Überwachungsschaltung nach einem der Ansprüche 1 bis 3, weiter umfassend:
eine Anzeigeeinheit (106);
wobei die Anzeigeeinheit (106) Leuchtanzeigen (84, 86, 88 und 90) umfasst;
wobei die Leuchtanzeigen (84, 86, 88 und 90) unterschiedliche Targetpositionen anzeigen.

5. Überwachungsschaltung nach einem der Ansprüche 1 bis 4, ferner umfassend:
eine Alarmeinheit;
wobei die Alarmeinheit bei einer bestimmten Targetposition einen Alarm gibt.

6. Überwachungsschaltung nach einem der Ansprüche 1 bis 5, wobei die Überwachungsschaltung ausgestaltet ist einen Öffnungszustand einer Türe eines Laderaums eines Flugzeugs zu überwachen.

7. Ein Verfahren zur Überwachung einer Position eines Targets, das folgende Schritte umfasst:
Bereitstellen eines induktiven Systems (6) mit einer Vielzahl von Luftspulen (8, 30) und einer Vielzahl von Kondensatoren (24, 26),
Bilden von zumindest zwei Schwingkreisen mit der Vielzahl von Luftspulen (8, 30) und der Vielzahl von Kondensatoren (24, 26), die magnetisch gekoppelt sind,
wobei das induktive System mit einer Auswerteinheit verbunden ist, die zumindest zwei Bandfiltern aufweist,
wobei die Mittenfrequenz (38) eines ersten Bandfilters (8) nahe einer ersten Frequenz liegt,
wobei die erste Frequenz eine untere Eckfrequenz des Frequenzganges des induktiven Systems (6) bei angenähertem Target ist,
wobei der erste Bandfilter (8) ausgebildet ist, ein erstes Signal mit der ersten Frequenz durchzulassen,
wobei die Mittenfrequenz (40) eines zweiten Bandfilter (10) eine zweite Frequenz ist,
wobei die zweite Frequenz eine Resonanzfrequenz des induktiven Systems (6) bei entferntem Target ist,
wobei der zweite Bandfilter (10) ausgebildet ist, ein zweites Signal mit der zweiten Frequenz durchzulassen;
Annähern des Targets (20) an die Luftspulen (24, 26) derart, dass ein Frequenzgang des induktiven Systems (6) verändert wird, so dass bei angenähertem Target an das induktive System (6) die Bandbreite des Frequenzgangs des induktiven Systems (6) erhöht wird;
Auswerten der Änderung des Frequenzganges zur Überwachung des Targets.

8. Verfahren nach Anspruch 7, wobei das Target eine Türe ist.

## Claims

1. A monitoring circuit for monitoring the position of a target, comprising:
an inductive system (6);
wherein the inductive system (6) comprises a multitude of air core inductors (28, 30); and
wherein the inductive system comprises a multitude of capacitors (24, 26);
wherein the multitude of air core inductors (28, 30) and the multitude of capacitors (24, 26) form at least two resonant circuits, which are magnetically coupled;
wherein the inductive system is adapted such that depending on the distance between the target (20) and the inductive system a frequency response (34, 26) of the inductive system (6) is changed, such that when the target is close to the inductive system (6) the bandwidth of the frequency response of the inductive system (6) is increased;
further comprising an evaluation unit (104);
wherein the evaluation unit (104) is adapted to differentiate between at least two frequencies (38, 40),
wherein the evaluation unit comprises:
at least two band filters (8, 10);
wherein the centre frequency (38) of a first band filter (8) is close to a first frequency;
wherein the first frequency is a lower cut-off frequency of the frequency response of the inductive system (6) when the target is close to the inductive system;
wherein the first band filter (8) is adapted to allow a first signal with the first frequency to pass;
wherein the centre frequency (40) of a second band filter (10) is a second frequency;
wherein the second frequency is a resonance frequency of the inductive system (6) when the target is remote to the inductive system;
wherein the second band filter (10) is adapted to allow a second signal with the second frequency to pass.

2. The monitoring circuit of claim 1, further comprising:
a saw-tooth generator (2);
a voltage controlled oscillator (4);
wherein the saw-tooth generator and the voltage controlled oscillator constitute a sweep signal generator (18) which cycles through a predetermined frequency spectrum;
wherein the sweep signal generator (18) is adapted to excite the inductive system (6) with the frequency spectrum.

3. The monitoring circuit of claim 1 or 2, wherein the evaluation unit further comprises:
a multitude of comparators (80, 82);
wherein the comparators (80, 82) are adapted to furnish output signals depending on the comparison between the first and the second signals.

4. The monitoring circuit of one of claims 1 to 3, further comprising:
a display unit (106);
wherein the display unit (106) comprises luminous indicators (84, 86, 88 and 90);
wherein the luminous indicators (84, 86, 88 and 90) display different target positions.

5. The monitoring circuit of one of claims 1 to 4, further comprising:
an alarm unit;
wherein the alarm unit issues an alarm at a defined target position.

6. The monitoring circuit of one of claims 1 to 5, wherein the monitoring circuit is adapted to monitor an opening state of a door of a cargo hold of an aircraft.

7. A method for monitoring the position of a target, comprising the following steps:
providing an inductive system (6) with a multitude of air core inductors (8, 30) and a multitude of capacitors (24, 26);
forming of at least two resonant circuits with the multitude of air core inductors (8, 30) and the multitude of capacitors (24, 26), which are magnetically coupled,
wherein the inductive system is connected to an evaluation unit comprising at least two band filters,
wherein the centre frequency (38) of a first band filter (8) is close to a first frequency;
wherein the first frequency is a lower cut-off frequency of the frequency response of the inductive system (6) when the target is close to the inductive system;
wherein the first band filter (8) is adapted to allow a first signal with the first frequency to pass;
wherein the centre frequency (40) of a second band filter (10) is a second frequency;
wherein the second frequency is a resonance frequency of the inductive system (6) when the target is remote to the inductive system;
wherein the second band filter (10) is adapted to allow a second signal with the second frequency to pass,
making the target (20) approach the air core inductors (24, 26) such that a frequency response of the inductive system (6) is changed such that when the target is close to the inductive system (6) the bandwidth of the frequency response of the inductive system (6) is increased;
evaluating the change in the frequency response for monitoring the target.

8. The method of claim 7, wherein the target is a door.

## Revendications

1. Circuit pour la surveillance d'une position d'une cible, comprenant :
un système inductif (6) ;
le système inductif (6) comprenant une multiplicité de bobines à air (28, 30) ; et
le système inductif comprenant une multiplicité de condensateurs (24, 26) ;
la multiplicité de bobines à air (28, 30) et la multiplicité de condensateurs (24, 26) formant au moins deux circuits oscillants, couplés magnétiquement ;
le système inductif étant configuré pour modifier, en fonction de la distance de la cible (20) par rapport au système inductif, une réponse en fréquence (34, 36) du système inductif (6), de sorte que la largeur de bande de la réponse en fréquence du système inductif (6) est accrue dans la position d'approche de la cible du système inductif (6),
comprenant en outre une unité d'évaluation (104),
l'unité d'évaluation (104) étant réalisée pour différencier au moins deux fréquences (38, 40),
l'unité d'évaluation comprenant :
au moins deux filtres passe-bande (8, 10) ;
la fréquence centrale (38) d'un premier filtre passe-bande (8) étant proche d'une première fréquence ;
la première fréquence étant une fréquence limite inférieure de la réponse en fréquence du système inductif (6) dans la position d'approche de la cible ;
le premier filtre passe-bande (8) étant réalisé pour laisser passer un premier signal de la première fréquence ;
la fréquence centrale (40) d'un second filtre passe-bande (10) étant une seconde fréquence ;
la seconde fréquence étant une fréquence de résonance du système inductif (6) en position d'éloignement de la cible ;
le second filtre passe-bande (10) étant réalisé pour laisser passer un second signal de la seconde fréquence.

2. Circuit de surveillance selon la revendication 1, comprenant en outre :
un générateur d'impulsions en dents de scie (2) ;
un oscillateur contrôlé en tension (4) ;
le générateur d'impulsions en dents de scie et
l'oscillateur contrôlé en tension réalisant un wobulateur (18), qui balaye un spectre de fréquences prédéfini ;
le wobulateur (18) étant réalisé pour exciter le système inductif (6) avec le spectre de fréquences.

3. Circuit de surveillance selon l'une des revendications 1 et 2, l'unité d'évaluation comprenant en outre :
une multiplicité de comparateurs (80, 82) ;
les comparateurs (80, 82) étant réalisés pour fournir des signaux de sortie en fonction de la comparaison du premier et du second signal.

4. Circuit de surveillance selon l'une des revendications 1 à 3, comprenant en outre :
une unité d'affichage (106) ;
l'unité d'affichage (106) comprenant des affichages lumineux (84, 86, 88 et 90) ;
les affichages lumineux (84, 86, 88 et 90) indiquant des positions de cible différentes.

5. Circuit de surveillance selon l'une des revendications 1 à 4, comprenant en outre :
une unité d'alarme ;
l'unité d'alarme émettant une alarme pour une position définie de la cible.

6. Circuit de surveillance selon l'une des revendications 1 à 5, le circuit de surveillance étant configuré pour surveiller un état d'ouverture d'une porte de soute d'un avion.

7. Un procédé destiné à surveiller une position d'une cible, procédé qui comprend les étapes suivantes :
mise en place d'un système inductif (6) avec une multiplicité de bobines à air (8, 30) et une multiplicité de condensateurs (24, 26),
formation d'au moins deux circuits oscillants avec la multiplicité de bobines à air (8, 30) et la multiplicité de condensateurs (24, 26), couplés magnétiquement,
le système inductif étant relié à une unité d'évaluation, qui présente au moins deux filtres passe-bande,
la fréquence centrale (38) d'un premier filtre passe-bande (8) étant proche d'une première fréquence,
la première fréquence étant une fréquence limite inférieure de la réponse en fréquence du système inductif (6) dans la position d'approche de la cible,
le premier filtre passe-bande (8) étant réalisé pour laisser passer un premier signal de la première fréquence,
la fréquence centrale (40) d'un second filtre passe-bande (10) étant une seconde fréquence,
la seconde fréquence étant une fréquence de résonance du système inductif (6) dans la position d'éloignement de la cible,
le second filtre passe-bande (10) étant réalisé pour laisser passer un second signal de la seconde fréquence ;
approche de la cible (20) des bobines à air (24, 26) de telle sorte qu'une réponse en fréquence du système inductif (6) est modifiée, si bien que, dans la position d'approche de la cible du système inductif (6), la largeur de bande de la réponse en fréquence du système inductif (6) est accrue ;
évaluation de la modification de la réponse en fréquence pour la surveillance de la cible.

8. Procédé selon la revendication 7, la cible étant une porte.
